# EUROPEAN PATENT APPLICATION

(11) **EP 3 940 888 A1**
(43) Date of publication of application: **19.01.2022**
(21) Application number: 21165143.5
(22) Date of filing: 26.03.2021
(51) Int. Cl.: H01R 12/62, H01R 4/02, H01R 43/02, H05K 1/11, H05K 3/36

(54) **ELECTRICAL CONTACT BETWEEN AN ELECTRICAL CONDUCTOR OF A CONDUCTOR CABLE AND A CONNECTING COUNTERPART, CELL CONNECTING SYSTEM FOR A VEHICLE BATTERY MODULE AND METHOD FOR MANUFACTURING THE CELL SYSTEM**

(30) Priority: 05.05.2020 DE 102020112089; 27.03.2020 EP 20305353; 04.02.2021 EP 21305149
(71) Applicant: TE Connectivity Germany GmbH, 64625 Bensheim (DE); TE Connectivity Belgium BVBA, 8020 Oostkamp (BE); Tyco Electronics France SAS, 95300 Pontoise (FR)
(72) Inventor: HENLE, Martin, 73485 Unterschneidheim (DE); EBERHARDT, Szilard, 91550 Dinkelsbühl (DE); WAGNER, Marco, 67360 Lingenfeld (DE); DALINO, Olivier, 78600 Maisons Laffitte (FR); LIEBAERT, Koen, 8810A Lichtervelde (BE); BERIKAI VASU, Aniruddha, 64293 Darmstadt (DE); DRESSEL, Andre Martin, 68623 Lampertheim (DE); BRANDT, Jochen, 73495 Stoedtlen (DE); JOEST, Christopher, 69517 Gorxheimertal (DE); RENNEFELD, Christoph, 61462 Koenigstein (DE); CALLIES, Thorsten, 67551 Worms (DE); BRABETZ, Florian, 64579 Gernsheim (DE); HAUCK, Uwe, 14532 Kleinmanchow (DE); GOLLEE, Ralf, 14621 Schoenwalde-Glien (DE); BLUMENSCHEIN, Rudi, 73479 Ellwangen (DE); TOTH, Gerzson, 68307 Mannheim (DE); SINDER, Josef, 73479 Ellwangen (DE)
(74) Representative: Grünecker Patent- und Rechtsanwälte PartG mbB

(57) **Abstract**

Device with an electrical contact between an electrical conductor (3) of a flat conductor cable (1) and an electrical connection counterpart (2), where the conductor (3) is embedded in a contact plane (13) in an insulation sheath (4) of the flat conductor cable (1), where the electrical conductor (3) is stripped of the insulation sheath (4) in a predetermined contact section (5) at least on one contact side (7), where the contact section (5) of the conductor is bent out with the contact side (7) from the contact plane (13) to beyond the insulation sheath (4), where the contact side (7) of the contact section (5) of the conductor (3) rests on the electrical connection counterpart (2) and is connected directly to the electrical connection counterpart (2). The invention also relates to a cell connecting system for a vehicle battery module, in particular for an electric or hybrid vehicle. It comprises a contact element for receiving an electrical pole of at least one battery cell, a sensing cable comprising a wire electrically and mechanically connecting a cell monitoring and balancing unit and the contact element. The cell connecting system is characterized in that the surface of the wire and/or the contact element comprises surface area enhancing features in the area of contact with each other. The surface area enhancing features improve the welding process as higher welding forces with more material transfer between the welding parts can be achieved. The invention also relates to a method to manufacture the cell connecting system.

## Description

The invention relates to a configuration of an electrical contact between an electrical conductor of a conductor cable, in particular a flexible flat conductor cable, and an electrical connection counterpart and a method for producing a device with electrical contact between an electrical conductor of a conductor cable, in particular a flexible flat conductor cable, and an electrical contact.

The invention also relates to a cell connecting system for a vehicle battery module, in particular for an electric or hybrid vehicle, comprising a contact element for receiving an electrical pole of at least one battery cell and a sensing cable comprising a wire electrically and mechanically connecting a cell monitoring unit and the contact element. The invention also relates to a method for attaching a sensing cable to a contact element of a cell connecting system as described above.

An electrical connection arrangement is known from EP 0 699 353 B1, where a flexible circuit arrangement is connected to a planar substrate, where the flexible circuit arrangement comprises a flexible flat strip of a circuit arrangement, where the circuit arrangement is bent back onto itself at least with one end in the longitudinal direction to form an elastic spring such that the upper side of the section that is bent back is located adjacent to the surface of the section of the strip that is not bent back. The conductors are not insulated on the surface side avert the surface that is bent back so that they can be pressed resiliently against conductive traces of the planar substrate. In a further embodiment, the flexible flat conductor cable comprises an indentation in the direction of the contacts, where the indentation rests on the contacts.

A first object of the invention is to provide an improved device with an electrical contact between an electrical conductor of a conductor cable, in particular a flexible flat conductor cable, and a connection counterpart and an improved method for establishing electrical contact between an electrical contact and a conductor of a conductor cable, in particular a flexible flat.

Cell connecting systems are known in the art, e.g. from DE102014219178A1 and are used in battery modules of electrical or hybrid vehicles to connect a plurality of battery cells with each other. To be able to monitor the status of the cells, it is necessary to monitor parameters, e.g. the cell temperature, the capacity or the loading status. To do so, a monitoring unit is electrically connected via an electrical cable to each one of the cells via the contact element of the cell connecting system. The monitoring unit can also be used to balance the cells. In this case, it could be called monitoring and balancing unit.

To ensure a sufficient long lifetime of the battery module it is important to realize connections that are electrically and mechanically stable even in daily use during which vibrations, shocks etc. put mechanical stress onto the connections. The connection between the cable and the cell connecting system is realized using ultrasonic welding.

Car manufactures therefore impose strict requirements on the reliability of the connection. A 90° peel tension test, well known in the art, is carried out and the connection needs to support a Force of at least 7N before the connection breaks. During the 90° peel tension test a previously connected cable is bent to a 90° to be perpendicular to the contact surface. Then the force is measured at which the connection peels off. The machine capability characteristic value: Cmk should be larger than 1.67.

It is therefore a second object of the invention to improve the mechanical reliability and therefore the electrical condition and electrical connection and to thereby improve the monitoring possibility of a battery.

This first object is achieved, with a device with an electrical contact between an electrical conductor of a conductor cable, in particular a flexible flat conductor cable, and an electrical connection counterpart. The conductor is embedded in an insulation sheath of the conductor cable in a contact plane. The conductor is stripped of the insulation sheath at a predetermined contact section at least on one contact side of the electrical conductor. The contact section of the conductor is bent out of the contact plane with its contact side, in particular is bent to beyond the insulation sheath. The contact side of the contact section of the conductor rests on the electrical connection counterpart and establishes direct electrical contact with the electrical connection counterpart. In addition, the contact side of the electrical conductor is connected to the electrical connection counterpart in the region of the contact section.

The connection can be implemented by way of a welded connection, in particular a laser-welded connection or an ultrasound or ultrasonic-welded connection.

The connection counterpart can, e.g., be an electrical conductor strip, an electrical conductor plate or any other type of contact element.

In the region of the contact section, the insulation sheath of the conductor cable is not bent in the direction of the electrical connection partner. The conductor cable can be configured e.g. to be planar in the region of the contact section and transition in a planar manner in the longitudinal direction before and after the contact section into the adjoining regions of the conductor cable. This prevents additional mechanical stress on the conductor cable and the other conductors of the conductor cable in the region of the contact section. Since, in this embodiment, only the electrical conductor is configured to be bent in the direction of the electrical connection counterpart, the processing effort, in particular the mechanical processing effort, for establishing the electrical contact is reduced. In addition, a plurality of electrical contacts of neighboring conductors that are offset in the longitudinal direction of the conductor cable with respect to each other, can be realized in this way, since no flexing of the conductor cable in the direction of the electrical connection counterpart is required. The conductor cable can be configured to be planar and smooth in the region of the contact section. An overall planar support of the conductor cable on the connection counterpart can thus be obtained.

In one embodiment, the contact section of the electrical conductor is bent with the contact side in a first direction out of the contact plane to beyond an outer side of the insulation sheath. The contact side of the contact section of the electrical conductor then rests on the electrical connection counterpart and is directly connected to the electrical connection counterpart. The conductor cable is bent in a second direction in the region of the contact section, i.e. the insulation sheath of the conductor cable just outside the contact section, such that the second direction points in the direction opposite to the first direction. A preload is exerted upon the electrical conductor due to flexing of the conductor cable in a direction opposite to the bend of the electrical conductor. Therefore, the contract section of the electrical conductor is preloaded in the direction towards the connection counterpart and can be pressed onto the electrical connection counterpart with a higher pressing force. An electrical connection between the electrical conductor and the electrical connection counterpart can thus be established with higher quality and using a simpler method. In particular, it is not necessary for the electrical conductor itself to be pressed onto the electrical connection counterpart in the region of the contact section with mechanical tools. For example, in the case of a laser-welded or ultrasonic welded connection, the electrical and mechanical connection between the electrical connection counterpart and the electrical conductor can additionally be improved in this manner. Furthermore, there is more free space in the region of the contact section of the conductor in this embodiment during assembly. The connection between the conductor and the connection counterpart can therefore be established more easily.

In a further embodiment, the bending of the contact section can be realized such that no stretching of the electrical conductor occurs in the bent regions. Thereby a reduction of the cross-section can be prevented. Thus, a mechanical harming of the contact section can be prevented.

In a further embodiment, the contact side of the contact section is connected to the electrical connection counterpart by way of several contact points. In this way, the mechanical connection between the electrical conductor and the electrical connection counterpart is improved. Furthermore, the electrical connection between the electrical conductor and the electrical connection counterpart is likewise improved. For example, the contact points can be produced with the aid of laser welding. In this embodiment, a contact point can be produced by a spirally formed laser weld seam. However, other shapes and/or methods, like ultrasonic welding, for realizing the contact points can also be used.

In a further embodiment, the contact section of the electrical conductor is divided into two partial sections perpendicular to the longitudinal direction of the conductor cable. In this embodiment, at least one partial section of the electrical conductor rests with the contact side on the electrical connection counterpart and is mechanically and electrically connected to the electrical connection counterpart.

In a further embodiment, at least a part of the contact section of the electrical conductor is embedded into insulating material, in particular is embedded in electrically insulating potting material. Both electrical insulation of the contact section of the electrical conductor as well as mechanical protection of the contact section of the electrical conductor are achieved in this way.

In a further embodiment, the electrical connection counterpart and the electrical conductor are formed from different electrically conductive materials, where in particular the electrical connection counterpart can be formed from aluminum and the electrical conductor from copper. Good electrical contact between the conductor and the connection counterpart is achieved with the inventive device described, even when using different electrically conductive materials, in particular when using copper and aluminum. The laser-welded or ultrasonic welded connection is particularly suitable for establishing a good electrical and a sufficient mechanical connection between aluminum and copper.

In one embodiment, the electrical connection counterpart is a contact of an electrical terminal of a battery, in particular a vehicle battery. The battery can be, for example, part of an arrangement of several batteries, where the electrical conductor is used, for example, to carry out a voltage measurement on a battery.

In a further embodiment, the contact section can be at least partially embossed into the connection counterpart. Embossing has the advantage that during production it becomes possible to connect the two parts without the need of an additional clamping step to hold the two parts together. Thus, a more efficient manufacturing process can be used and at the same time, a sufficiently high mechanical strength can be realized.

In a further embodiment, the interface between the contact section and the electrical connection counterpart can be positioned, below the surface of the connection counterpart immediately adjacent the interface, in particular up to about 0,1 to 0,5mm, more in particular up to about 0,2 to 0,3 mm below the surface. This further improves the mechanical strength.

In a further embodiment, the surface of the contact section and the surface of the electrical connection counterpart can comprise mating surface area enhancing features at the interface. Using an embossing stamp having a structured surface, e.g. having a plurality of regularly arranged pyramidal projections at its surface, the pattern is transferred onto the contact section and extends through to the surface side of the contact section interfacing the connection counterpart. This can further improve the attachment forces prior to the final connecting step, e.g. using welding.

The second object the invention is achieved with a cell connecting system for a vehicle battery module, in particular for an electric or hybrid vehicle, according to claim 23 which comprises a device as described above,- wherein the electrical connection counterpart comprises a contact element for receiving an electrical pole of at least one battery cell, the conductor cable, in particular the flexible flat conductor cable, comprises a sensing cable comprising a wire electrically and mechanically connecting a cell monitoring unit and the contact element, characterized in that the surface of the wire and/or the contact element comprises surface area enhancing features in the area of contact with each other. By enhancing the surface area compared to a smooth surface, the mechanical contact force can be enhanced due to a larger interacting surface. According to this embodiment, the first and second object of the invention is achieved.

The second object of the invention is also achieved with the cell connecting system for a vehicle battery module, in particular for an electric or hybrid vehicle, according to claim 24. The cell connecting system comprises a contact element for receiving an electrical pole of at least one battery cell, a sensing cable comprising a wire electrically and mechanically connecting a cell monitoring unit and the contact element. It is characterized in that the surface of the wire and/or the contact element comprises surface area enhancing features in the area of contact with each other. By enhancing the surface area compared to a smooth surface the mechanical contact force can be enhanced due to a larger interacting surface.

According to an inventive variant, the surface area enhancing features can comprise a plurality of bumps. The contact surface area can be easily enhanced by forming bumps on the surface.

According to an inventive variant, the bumps can extend linearly, in particular in parallel to the longer side of the area of contact. Such a pattern can be easily realized

According to an inventive variant, the bumps can have a pyramidal shape, in particular a peaked pyramidal shape. Such a pattern even further enhances the surface area and provides contact flanks in different directions.

According to an inventive variant, the pyramidal shape can be a rectangular, in particular square base shape, and a flank-angle of about 30° to 60°, in particular 45°. According to an inventive variant, the bumps have a height of up to 0,5mm, in particular up to 0,2mm, more in particular a height of up to 0,1mm. According to an inventive variant, the peaks of directly neighbouring bumps can have a distance from each other of up to 5mm, in particular of up to 0,2mm. These dimensions lead to improved contact forces compared to flat smooth surfaces.

According to an inventive variant, the wire and the contact element can be welded together, in particular ultrasonic welded together. The surface area enhancing features allow a higher and more stable welding force because a higher material transfer can occur between the welding parts.

According to an inventive variant, the contact element and the wire can be made of different materials, in particular of aluminium and copper respectively. The invention even allows to combine two different materials and to obtain satisfying connections. When using materials with a thin electric isolating oxide layer on the surface, it is preferable to realize the surface area enhancing features at least on this material.

According to an inventive variant, the cell connecting system can have a plurality of contact elements arranged in two rows, allowing a serial electrical connection of battery cells, and wherein one of mutually opposing contact elements is electrically and mechanically connected with the wire of the sensing cable.

According to an inventive variant, the sensing cable can comprise a plurality of parallel wires, in particular flat wires, embedded in an electrical isolation, wherein, wherein each one of the wires that is connected to a contact element is electrically and mechanically connected to a different one of the contact elements and wherein the electrical isolation is removed in each area of contact.

In addition, concerning the first object of the invention, a method for producing a device with an electrical contact between an electrical conductor of a conductor cable, in particular a flexible flat conductor cable, and an electrical connection counterpart is provided according to claim 6. For this purpose, a conductor cable, in particular a flexible flat conductor cable, is provided which comprises at least one, in particular several electrical conductors, which are embedded in a contact plane in an insulation sheath of the conductor cable. At least one of the electrical conductors is stripped of the insulation sheath at a predetermined contact section, at least on one contact side. For example, the electrical conductor in the contact section can also be stripped of the insulation sheath on all sides. The method comprises the steps of: a) bending the contact side of the contact section of the electrical conductor out of the contact plane up to at least one outer side of the insulation sheath, step b) placing, in particular after the conductor has been bent out of the contact plane, the conductor cable, in particular a flexible flat conductor cable, on the connection counterpart, step c) placing the contact side of the contact section of the electrical conductor on the electrical connection counterpart and, then step d) connecting the contact side of the contact section of the conductor to the electrical connection counterpart. In one embodiment in step d) the contact side of the electrical conductor is welded to the electrical connection counterpart.

It is advantageous in this method that the insulation sheath, in the region of the contact section, is not bent in the direction towards the connection counterpart. This leaves more space for the connection of the conductor to the connection counterpart. The insulation sheath of the conductor cable can be arranged in the region of the contact section either in a manner planar to the upper side of the electrical contact, or it can have a bend leading away from the electrical connection counterpart. Both embodiments allow for simple and reliable electrical contact between the electrical conductor and the electrical connection counterpart.

In one embodiment, the contact side of the electrical conductor is welded to the electrical connection counterpart with the aid of a laser. For example, one or more contact points or weld spots can be formed between the electrical conductor and the electrical connection counterpart. In particular, the laser can form a laser seam, which is, for example, spirally shaped and forms a contact point. As an alternative ultrasonic welding can be used.

According to an embodiment, the method can comprise a step of downholding the contact side of the electrical conductor towards the electrical connection counterpart prior to welding using a pressure wave formed by initiating a phase transition in a pressure creating material, in particular from a liquid phase or solid phase to a gas phase, and/or an explosion. Forming such a pressure wave to push the contact section onto the electrical connection counterpart has the advantage that the manufacturing process can be realized without clamping or at least with less clamping as at most a clamping is needed to realize a first weld spot. The pressure creating material can be of the same material as used to realize the connection, e.g. a weld material or a glue. In a variant, it can be a combustible material like CH₃NO₂.

According to an embodiment, the pressure wave formation step can comprise a step of hitting the pressure creating material with one or more laser pulses, in particular using the same laser as for welding. Thus, the same laser used for realizing the weld can be used to create the pressure wave. A first shot can be used to ignite a droplet of combustible material or one or more pulses can be used to evaporate a small droplet of the phase transitioning material, e.g. the weld or glue. The next following pulse can then be used to realize the weld between the contact section and the electrical connecting counterpart.

According to an embodiment, the pressure creating material can be provided in the form of a droplet or a cladding on or over the contact section. By providing the pressure creating material in vicinity to the contact section, the downholding effect following the creation of the pressure wave can be optimized.

Prior to the electrical conductor being placed on the electrical connection counterpart and prior to the conductor being welded to the connection counterpart, the conductor cable in one embodiment is bent in a second direction in the region of the contact section, i.e. the insulation sheath of the conductor cable just outside the contact section, The second direction is opposite to the first direction in which the electrical connection counterpart is bent. By forming the bend in the conductor cable in a direction opposite to the bending direction of the electrical conductor, a preload onto the electrical conductor is generated which enables easier and better electrical contact between the electrical conductor and the electrical connection counterpart. This means that the use of special hold-down systems is no longer needed, at least in part or even entirely.

In a further embodiment, the contact section of the electrical conductor is divided perpendicular to the longitudinal direction into a first and a second partial section. At least one first partial section of the electrical conductor is bent out of the contact plane. Depending on the embodiment selected, the electrical conductor can also first be bent out of the contact plane and the electrical conductor can subsequently be divided into two partial sections in the region of the contact section. At least one first partial section is placed on the electrical connection counterpart and welded with the contact side to the electrical connection counterpart. Depending on the embodiment selected, both partial sections can be placed onto the electrical connection counterpart and connected to the electrical connection counterpart in an electrically conductive manner.

The separation of the electrical conductor in the region of the contact section into two partial sections provides the advantage that the actual conductor cable can run in a planar manner and the conductor stripped of insulation can be configured as a spring element largely free of stretching and therefore without a reduction in the cross section and that the flexing of the electrical conductor out of the contact plane is easier and is possible with less mechanical stress on the electrical conductor. In this way, even thick conductors can be bent out of the contact plane with little stress. The partial sections can be guided out of the insulation material of the conductor cable with little mechanical deformation with the aid of the partial sections, even in the case of thick insulation sheaths with a corresponding bend in the partial sections. In particular in the case of thicker insulation sheaths, this reduces the mechanical stress on the electrical conductor in the region of the contact section. In this way, the mechanical stress and the deformation of the electrical conductor are reduced so that the electrical contact is improved in terms of a long-life cycle. In particular, the mechanical joining of the electrical conductor can be protected in this way and less damaged when it is bent out of the contact plane. This also improves the long-term stability of the electrical contact. In addition, there are fewer influences on the cross section of the electrical conductor in the region of the contact section. In this manner, the parameters for connecting, in particular for welding the electrical conductor to the electrical connection counterpart can be set more precisely. This also improves both the quality of the mechanical as well as the electrical contact between the electrical conductor and the electrical connection counterpart. Furthermore, the long-term stability of the electrical contact between the electrical conductor and the electrical connection counterpart is thus likewise increased. This is particularly advantageous for applications in the vehicle sector, since a vehicle is exposed to mechanical vibration stresses during operation and thermal loads, in particular high temperature fluctuations. The quality of the mechanical and electrical connection between the electrical conductor and the electrical connection counterpart of the battery is particularly important when establishing contact with electrical contacts of a battery of a vehicle.

According to an embodiment, the steps a) and c) can be realized at the same time by embossing the contact section in the electrical connection counterpart. Thus, the conductor cable with the contact section is placed on the electrical connecting counterpart and then using a stamping punch the contact section is bent towards and embossed into the surface of the electrical connection counterpart. In one step, it thus becomes possible to hold the two parts together so that no additional clamping of the two parts prior to welding is needed.

According to a variant, a stamping punch with a flat or structured surface can be used. Using a structured surface, e.g. regularly arranged pyramidal shapes, a surface pattern can be obtained on the surface side of the contact section that is actually facing the surface electrical connecting counterpart, which will be embossed in the same way to form a mating pattern on the surface of the counterpart. The higher surface area can improve the connecting forces between the two parts.

The second object of the invention in combination with the first object is achieved by a method as described above and with which a cell connecting system according to the second object of the invention can be obtained, wherein the surface area enhancing features are realized using a stamping punch or scratching tool or by laser structuring. Therefore, at the moment of realizing the electrical connection between the two parts, the electrical contact is improved.

The second object of the invention is also achieved with the method according to claim 36 for attaching a sensing cable to a contact element of a cell monitoring system according to the embodiments as described above. The method comprises a step of realizing the surface area enhancing features using a stamping punch or scratching tool or by laser structuring. The method allows obtaining improved connection forces compared to a connection of smooth surfaces. At the same time, the structuring of the surface can break thin oxidation layers on the surface of the wire and/or the contact element. Therefore, at the moment of realizing the electrical connection between the two parts, the electrical contact is improved.

According to an inventive variant, the stamping punch or the scratching tool or the laser structuring is applied on the side of wire and/or the contact element on which the electrical and mechanical connection will be established.

According to an inventive variant, the electrical and mechanical connection can be realized via welding, in particular ultrasonic welding. The surface area enhancing features allow a higher and more stable welding force because a higher material transfer can occur between the welding parts.

According to further variants, any embodiment and variants thereof related to the first inventive object can be combined with anyone and variants related to the second inventive object.

The invention may be understood by reference to the following description taken in conjunction with the accompanying figures, in which reference numerals identify features of the invention.
Fig. 1 shows a schematic perspective representation of a flexible flat conductor cable on an electrical contact;
Fig. 2 shows a schematic partial sectional representation of the flexible flat conductor cable and the electrical contact according to Figure 1;
Fig. 3 shows a cross section in the longitudinal direction of the flexible flat conductor cable of Figure 1;
Fig. 4 shows an embodiment of a flexible flat conductor cable with an electrical conductor that is bent out;
Fig. 5 shows a top view of a flexible flat conductor cable according to Figure 4, where the electrical conductor rests on the electrical connection counterpart;
Fig. 6 shows a partial section of a top view of the flexible flat conductor cable, where an electrical conductor is connected to the electrical connection counterpart by way of contact points or weld spots
Fig. 7 shows a schematic representation of a further embodiment of a flexible flat conductor cable, where an electrical conductor is connected with two partial sections to the electrical connection counterpart;
Fig. 8 shows a perspective representation with two partial sections of a flexible flat conductor cable with a view onto an underside of the flexible flat conductor cable, where two partial sections of an electrical conductor are led out of the insulation sheath;
Fig. 9 shows a perspective representation of a flexible flat conductor cable, where two partial sections of an electrical conductor rest on an electrical connection counterpart;
Fig. 10 shows a perspective with two partial sections of the arrangement of Figure 7;
Fig. 11 shows a partial sectional representation of the flexible flat conductor cable and the electrical contact according to Figure 7;
Fig. 12 shows the arrangement of Figure 11, where a partial section of the electrical conductor of the flexible flat conductor cable is embedded in insulating material;
Fig. 13 shows a schematic representation of batteries, the electrical terminals of which are contacted with conductors of a flexible flat conductor cable.
Figures 14a to 14e illustrate a schematic representation of a method to bend a contact section onto an electrical connection counter element according to an embodiment of the invention.
Figures 15a to 15c illustrate a schematic representation of a method to emboss a contact section into an electrical connection counter element according to an embodiment of the invention.
Fig. 16 illustrates a cell connecting system for a vehicle battery module according to the invention.
Figures 17a to 17c illustrate schematically variants of surface area enhancing features according to the invention.
Fig. 18 illustrates a stamping punch with peaked pyramids to form surface enhancing features in a wire.
Fig. 19 illustrates peel off forces for four practical examples according to the invention compared to a comparative example with smooth surface.

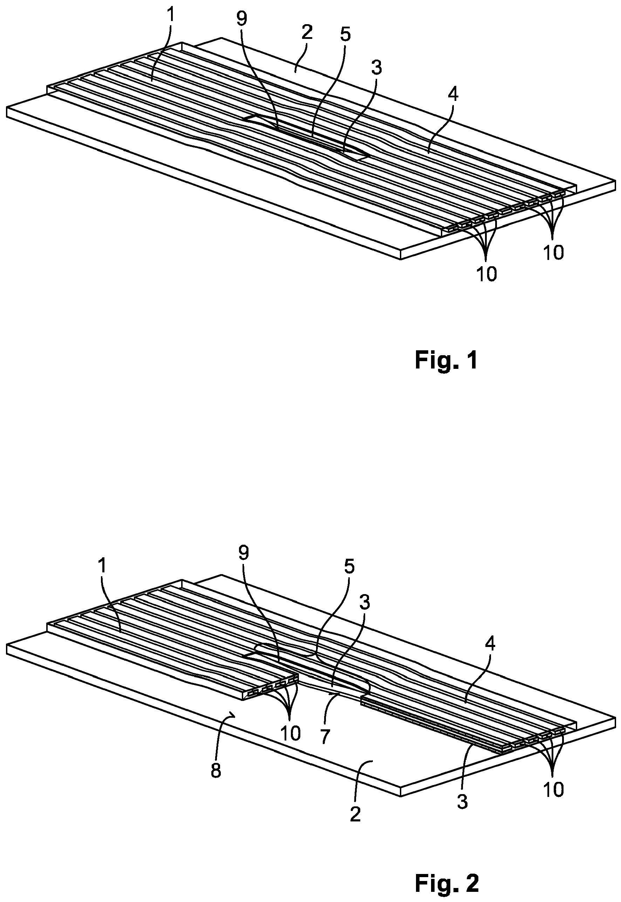

Figures 1 to 15 relate to embodiments in relation to the first object of the invention.

Figure 1 shows a schematic representation of a conductor cable 1 which rests on an electrical connection counterpart 2. In this and the following embodiments, a flexible flat conductor cable is used, but the invention is not limited thereto, any type of conductor cable having at least one electrical conductor embedded in an insulation sheath can be used.

The flexible flat conductor cable 1 comprises several electrical conductors 3, 10 which are embedded in an insulation sheath 4. In the embodiment shown, flexible flat conductor cable 1 comprises nine electrical conductors 3, 10 which are embedded in the insulation sheath 4. An electrical conductor 3 is stripped of its insulation sheath 4 in a contact section 5. This means that electrical conductor 3 is freed from the material of insulation sheath 4 on all sides in the region of contact section 5. In addition, electrical conductor 3 rests with the contact section with one contact side on electrical connection counterpart 2.

Figure 2 shows the arrangement of Figure 1 in a schematic partial cross-section that runs along electrical conductor 3. It can be clearly seen that electrical conductor 3 has been freed of insulation sheath 4 in the contact section 5. In addition, electrical conductor 3 rests with contact section 5 and with one contact side on the upper side of electrical connection counterpart 2. Remaining electrical conductors 10 of flexible flat conductor cable 1 are completely embedded in the insulation sheath. Depending on the embodiment selected, further electrical conductors 10 can also be stripped off the insulating material of the insulation sheath in a contact section and rest with one contact side on electrical connection counterpart 2. Viewed in the longitudinal direction of flexible flat conductor cable 1, the stripped contact sections of further electrical conductors 10 can be arranged at the same height or in different longitudinal sections of flexible flat conductor cable 1.

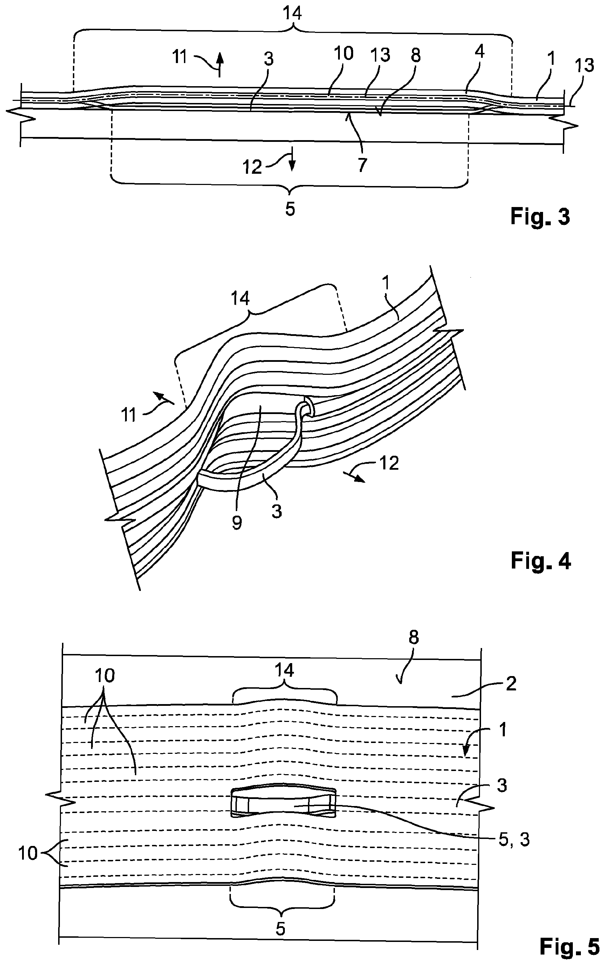

Figure 3 shows a schematic cross section of the arrangement of Figure 1. Insulation sheath 4 comprises a recess 9 in the region of contact section 5.

It can be seen in the illustration in Figure 3 that flexible flat conductor cable 1 rests laterally of the contact section 5 with insulation sheath 4 on the upper surface side 8 of the electrical connection counterpart 2 of the electrical contact. In the region of the contact section 5, however, flexible flat conductor cable 1 is bent upwardly in a second direction 11 from the upper surface side 8 of electrical contact 2. In addition, electrical conductor 3 is bent in the region of contact section 5 from a contact plane 13 of insulation sheath 4 in a first direction 12 downwardly in the direction towards the electrical connection counterpart 2. Contact plane 13, in which electrical conductors 3, 10 of the flexible flat conductor cable are arranged in insulation sheath 4, is typically formed at the center of the insulation sheath 4. The bending of the conductor 3 in the direction toward connection counterpart 2 enables a contact side 7 of the electrical conductor 3 to rest securely on the upper side 8 of the electrical contact 2. In addition, cable section 14, which is bent upwardly in second direction 11, can be used to exert a pretension of contact section 5 of electrical conductor 3 in the direction of the electrical connection counterpart 2. In addition, this results in easier bending of the conductor 3 in the direction of the connection counterpart 2 without having to deform conductor 3.

Depending on the embodiment selected, flexible flat conductor cable 1 can also rest in a planar manner on connection counterpart 2 in the region of contact section 5. In this embodiment, however, the conductor 3 is deformed, in particular stretched, to allow the flexion in the direction towards the connection counterpart 2.

Figure 4 shows, in a perspective representation, a further embodiment of a flexible flat conductor cable 1 with an electrical conductor 3 which is bent in the first direction 12 out of the insulation sheath 4. At the same time, a cable section 14 has a bent shape in a second direction 11, which is arranged opposite to the first direction 12, in the region of contact section 5 with respect to the remaining part of the flexible flat conductor cable 1 extending in a planar manner.

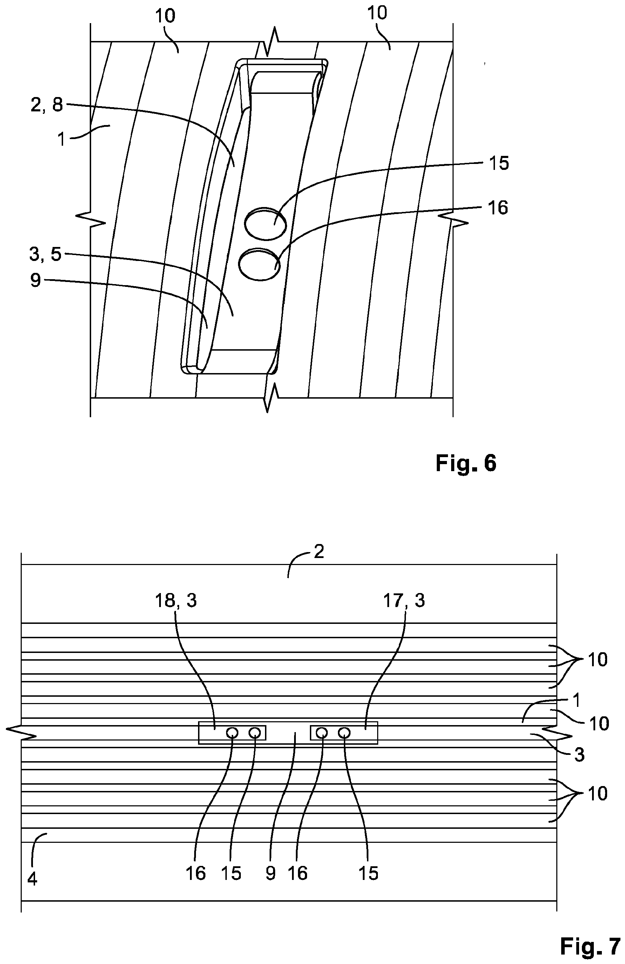

Figure 5 shows the flexible flat conductor cable 1 from Figure 4 which is placed on the electrical connection counterpart 2. Here, the contact section 5 of the electrical conductor 3 rests on the upper side 8 of the electrical connection counterpart 2. The flexible flat conductor cable 1 in this embodiment comprises six electrical conductors 3, 10, which are shown with dashed lines. The electrical conductor 3 is not yet mechanically connected with its contact section 5 to the electrical connection counterpart 2, but only rests on the upper side 8 of the electrical connection counterpart 2. In a subsequent method step, the contact section 5 of the electrical conductor 3 is connected to the upper side 8 of the electrical connection counterpart 2. For example, welded connections, adhesive connections, or solder connections can be used for this purpose. Laser-welded connections in particular can be used as the welded connections. Welding of the contact section 5 of the electrical conductor 3 to the upper side 8 of the electrical contact 2 is achieved with a laser beam. Depending on the embodiment selected, one or more weld spots 15 can be used, as shown in Figure 6. As an alternative to laser welding, ultrasonic welding could be used as well.

Figure 6 shows in an enlarged illustration a detail of the arrangement of Figure 5, where the electrical conductor 3 is welded to the electrical connection counterpart 2 using two weld spots 15, 16. Depending on the embodiment selected, only one weld spot or also more than two weld spots can be used. In addition, an elongated, rectangular, or jagged shape of the welded connection can also be selected instead of the round shape of the weld spot. For example, the welded connection can be created with the aid of a laser beam which is guided in a spiral shape from a center point of the weld spot to the edge region of the weld spot.

Figure 7 shows a perspective representation of a further device with electrical contact between an electrical conductor 3 of a flexible flat conductor cable 1 and an electrical connection counterpart 2. The representation in Figure 7 is schematic with a view from above onto the flexible flat conductor cable 1 that is shown placed onto the electrical connection counterpart 2. A recess 9 is introduced into the insulation sheath 4 of flexible flat conductor cable 1, so that a contact section 5 of electrical conductor 3 is stripped off the insulating material of the insulation sheath 4. In addition, the contact section 5 of electrical conductor 3 is divided into a first partial section 17 and a second partial section 18. The first and second partial sections 17, 18 are led out of the contact plane of the insulation sheath 4 downwardly with respect to the flexible flat conductor cable 1 and rest on the upper side 8 of the electrical connection counterpart 2. In addition, each partial section 17, 18 is electrically and mechanically connected to the electrical connection counterpart 2 with two respective weld spots 15, 16. Weld spots 15, 16 can be produced, for example, by laser welding.

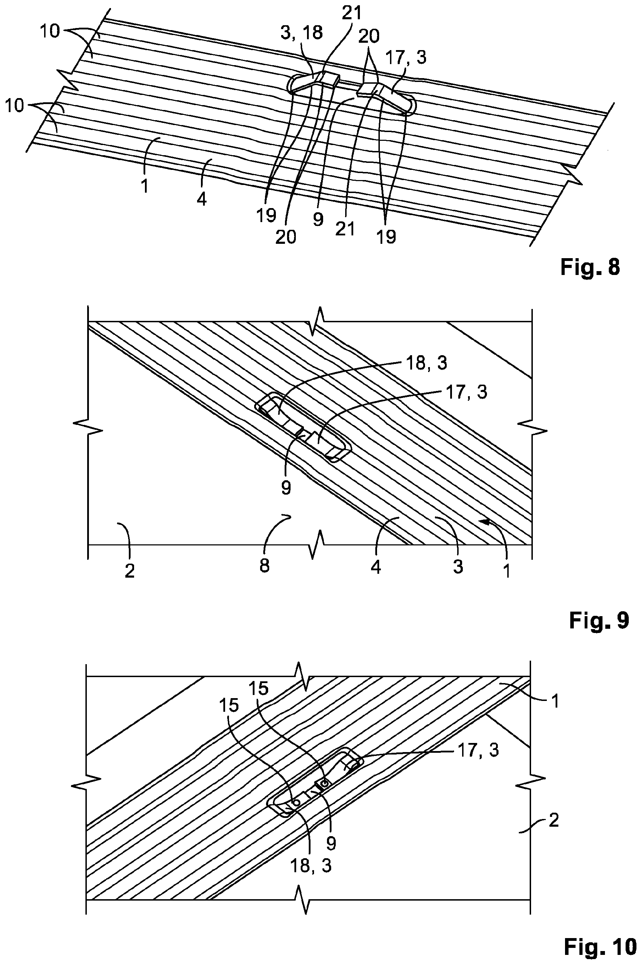

Figure 8 shows the flexible flat conductor cable 1 from Figure 7 before being placed on the electrical connection counterpart 2. Here, the partial sections 17, 18 of the electrical conductor 3 can be easily recognized which are bent out of the insulating sheath 4 of the flexible flat conductor cable 1. The partial sections 17, 18 are each divided into a first section 19 and a second section 20. First section 19 extends out from the contact plane 13 of the insulation sheath 4 and is inclined at a predetermined angle relative to contact plane 13. The first section 19 transitions to the second section 20 via a bend 21. Second section 20 has a smaller inclination relative to the contact plane 13 and can be arranged, for example, parallel to the plane of the flexible flat conductor cable 1. The first and second partial sections 17, 18 can be shaped identically so that first sections 19 each have the same angle relative to the plane of flexible flat conductor cable 1 and at which second sections 20 are arranged parallel to one another. This shape of partial sections 17, 18 enables a simplified and improved realisation of the electrical contacting between the electrical conductor 3 and the electrical connection counterpart 2.

Due to the shape of the partial sections 17, 18, the second sections 20 of the partial sections 17, 18 have a relatively large contact surface with the upper side 8 of the electrical contact 2 when the flexible flat conductor cable 1 is placed onto the electrical connection counterpart 2. The second sections 20 of the partial sections 17, 18 therefore lay in contact over a large area with the electrical connection counterpart 2. A large contact surface is thus given. In addition, a large surface for forming the connections between the connection counterpart 2 and the partial sections 17, 18 is present.

Figure 9 shows flexible flat conductor cable 1 from Figure 8 which is placed on an electrical connection counterpart 2 so that the partial sections 17, 18 rest with the second sections 20 on the upper side 8 of the electrical connection counterpart 2.

Figure 10 shows the arrangement of Figure 9 after the partial sections 17, 18 have each been welded with a weld spot 15 to electrical connection counterpart 2.

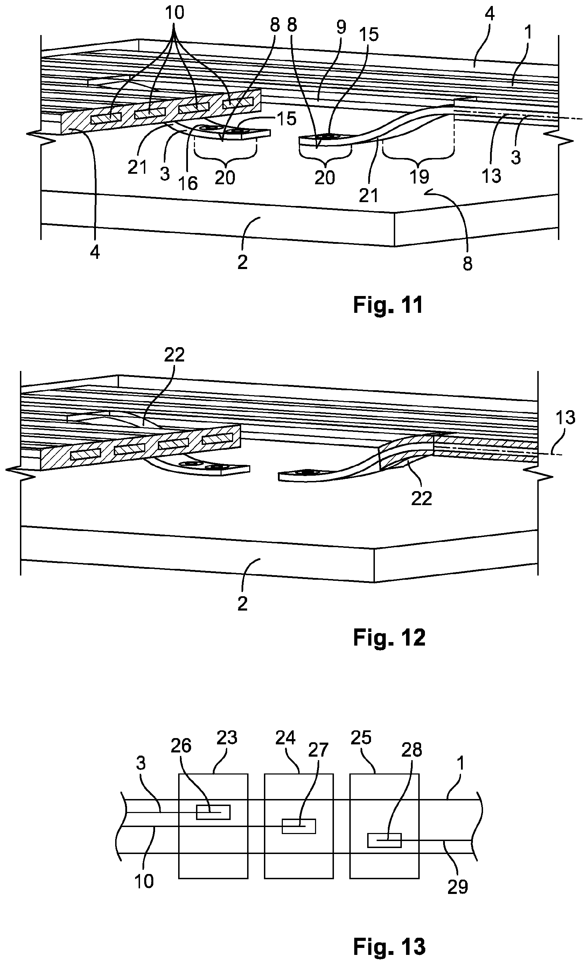

Figure 11 shows a schematic partial sectional representation of the arrangement of Figure 10, where the formation of the first sections 19 and the second sections 20 of the partial sections 17, 18 are clearly visible. In the embodiment of Figure 11, two weld spots 15, 16 are formed in the second sections 20 of the partial sections 17, 18 and connect the partial sections 17, 18 to the electrical connection counterpart 2.

Figure 12 shows a schematic partial cross-section through a further embodiment of Figure 7. In this embodiment, the first partial section 17 and the second partial section 18 are embedded in an insulating material 22. The insulating material 22 can be formed, for example, from electrically insulating potting material, e.g. plastic material. For example, the partial sections 17, 18 stripped off the insulation sheath 4 can be covered at least in part, in particular entirely, with the insulating material 22. A safe and reliable electrical insulation of the partial sections 17, 18 is thus achieved.

In a similar manner, the contact section 5 of the embodiments of Figures 1 to 6 can also be covered with the insulating material, in particular with the electrically insulating potting material.

Depending on the embodiment selected, the electrical connection counterpart 2 and the electrical conductor 3 can be formed from different materials. For example, the electrical connection counterpart 2 can be made of aluminum. In addition, electrical conductor 3 can be formed from copper.

Figure 13 shows, in a schematic representation, an arrangement of a battery system with several batteries 23, 24, 25, each battery having electrical terminals, some of terminals 26, 27, 28 being shown schematically as rectangles. In addition, a flexible flat conductor cable 1 is led across batteries 23, 24, 25. Flexible flat conductor cable 1 comprises an electrical conductor 3, a further electrical conductor 10, and an additional electrical conductor 29. Electrical conductors 3, 10, 29 are shown schematically only in partial sections, but are formed along the entire flexible flat conductor cable 1. In the embodiment shown, the electrical conductor 3 is connected in an electrically conductive manner to the first terminal 26 of the first battery 23, a further electrical conductor 10 to the second terminal 27 of the second battery 24, and an additional electrical conductor 29 to a third terminal 28 of the third battery 25 according to one of the previously described embodiments of Figures 1 to 12. For example, the arrangement of the battery is provided in a vehicle. Electrical terminals 26, 27, 28 of the batteries represent electrical contacts. Depending on the embodiment selected, only one battery can be provided with an electrical terminal that is connected to a conductor of the flexible flat conductor cable. The electrical contact of the electrical terminals of the batteries can be used to detect a voltage of the batteries to balance them and/or a temperature of the batteries. A battery has two terminals which are not shown in this schematic representation.

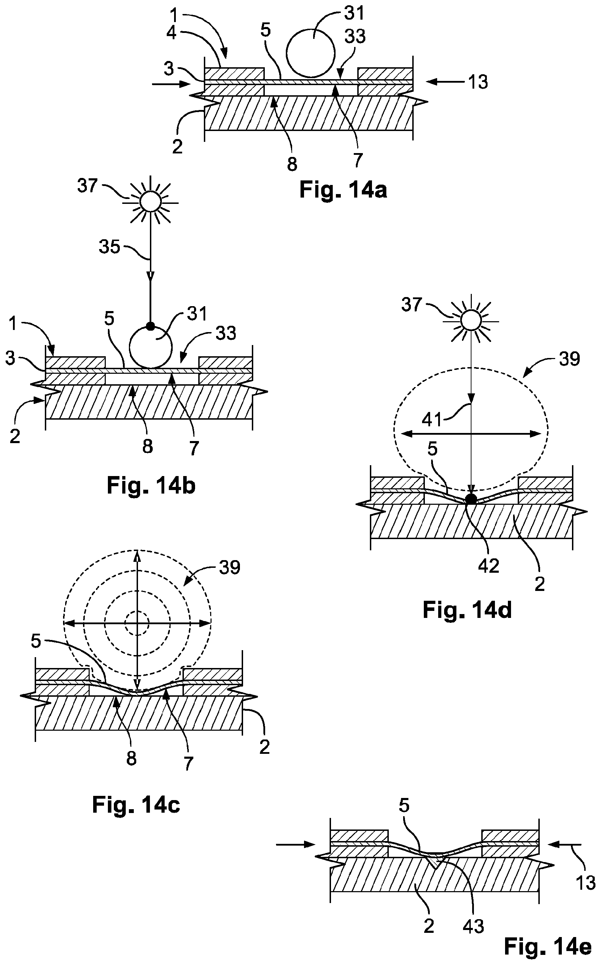

Figures 14a to 14e illustrate a further embodiment according to the invention. Features having the same reference numerals as already used in the description of the Figures above will not be described in detail again but reference made to thereto.

Figure 14a schematically illustrates a side cut view of the conductor cable, here in the exemplary form of a flexible flat conductor cable 1 positioned with its insulation sheath 4 on the electrical connection counterpart 2. The electrical conductor 3 is positioned in the contact plane 13 over its entire length. The contact section 5 is not yet bend towards the surface 8 of the electrical connection counterpart 2. A droplet 31 of a welding material or a glue of a combustive material or an explosive material is positioned on the surface side 33 opposite the contact side 7. Instead of a liquid material, a suitable solid material, e.g. in the form of an explosive cladding provided on the surface side 33 opposite the contact side 7, could also be used.

Figure 14b shows a laser pulse 35 emitted by a pulsed laser 37, impinging on the droplet 31.

Depending on the material used the droplet 31 will immediately evaporate or burn or explode due to the energy transfer. To do so a single laser pulse might be sufficient. In some applications, multiple pulses might be needed.

Following the phase transition, a pressure wave 39 is formed quickly expanding and pressing down the contact side 7 of the contact section 5 towards the surface 8 of the electrical connection counterpart 2. This is illustrated in Figure 14c.

Subsequently, and as illustrated in Figure 14d, a further laser pulse 41 is emitted by the laser 37 while the contact section 5 is still down hold by the pressure wave 39 and impinges on the contact section 5 to weld it to the electrical connection counterpart 2 in weld area 42

Figure 14e illustrates the final result. The contact section 5 is bent out of the contact plane 13 and is electrically and mechanically connected to the electrical connection counterpart 2. By pressing down the contact section 5 at the moment of the interaction with the laser a high quality weld 43 can be obtained.

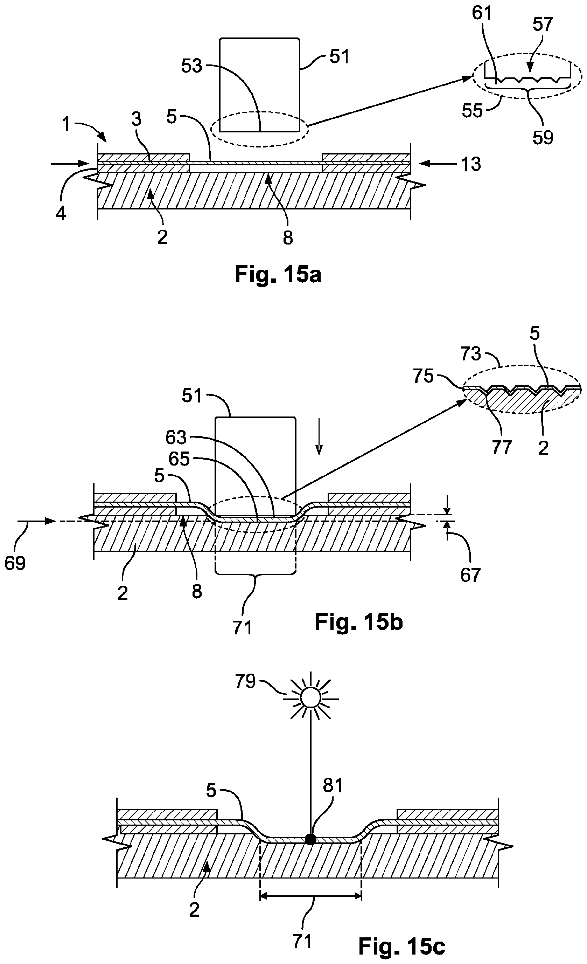

Figures 15a to 15c illustrate a further embodiment according to the invention. Features having the same reference numerals as already used in the description of the Figures above will not be described in detail again but reference made to thereto.

Figure 15a schematically illustrates a side cut view of the conductor cable, here in the exemplary form of a flexible flat conductor cable 1 positioned with its insulation sheath 4 on the electrical connection counterpart 2. The electrical conductor 3 is positioned in the contact plane 13 over its entire length. The contact section 5 is not yet bend towards the surface 8 of the electrical connection counterpart 2. A stamping punch 51 is positioned just above the contact section 5. The stamping surface 53 can be a flat surface with or without chamfered edges.

A variant of the embodiment is illustrated in the enlarged zone 55. Here the stamping surface 57 has a structured surface 59, e.g. a plurality of pyramidal shapes 61 that are regularly arranged over the stamping surface 57.

Figure 15b illustrates the result after the stamping punch 51 has been moved downwards and pushed against the contact section 5 and the surface 8 of the electrical connection counterpart 2. Under the pressure of the stamping punch 51, at least a part 63 of the contact section 5 has been bent and embossed into the surface 65 of the electrical connection counterpart 2. The height 67 of the interface plane 69 of the imprint compared to the surface 8 immediately adjacent the embossed area 71 is of the order of 0,1 to 0,5 mm, preferably, 0,2 to 0,4mm.

The enlarged zone 73 illustrates the interface 75 when using a stamping punch 51 with a structured surface 59 like illustrated Figure 15a. Here the contact section 5 and the electrical connection counterpart 2 have mating surface area enhancing features 77 at the interface 75. Embossing has the advantage that the two parts are positioned with respect to each other without needing additional clamping means, thereby simplifying the manufacturing process.

Subsequently, as illustrated in Figure 15c, a laser 79 is used to weld the contact section 5 to the electrical connection counterpart 2. One or more weld spots 81 can be realized in the embossed area 71 like in the embodiments mentioned above. As an alternative, ultrasonic welding could be used instead.

Thus, in this embodiment, the bending and pacing of the contact side on and into the surface 8 of the electrical connection counterpart 2 is realized in one step.

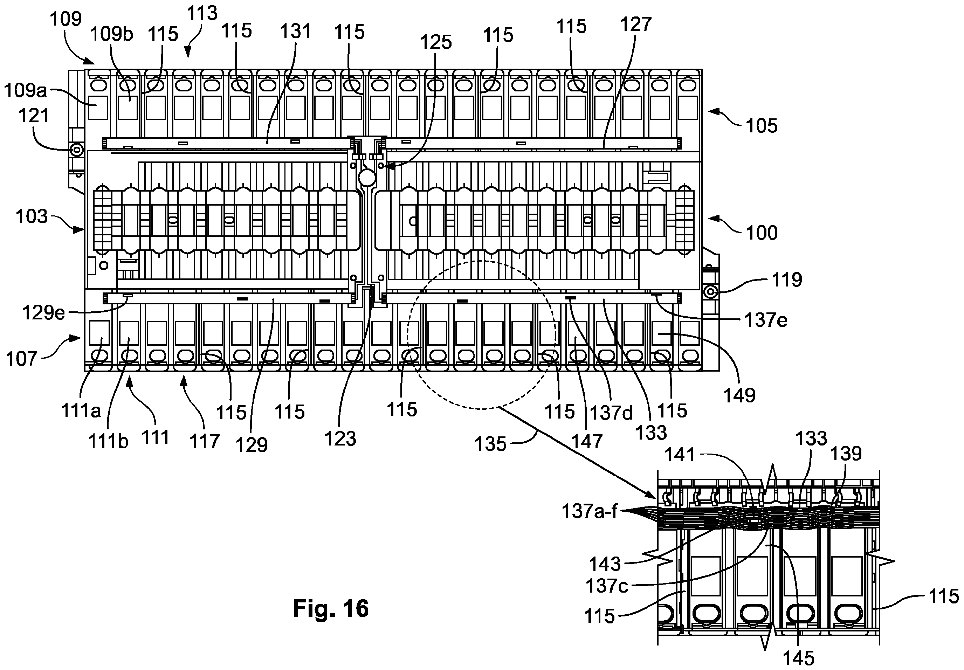

Figure 16 illustrates a cell connecting system 100 used for a battery module related to the second object of the invention.

Such a cell connecting system 100 is used in electric or hybrid vehicles. It receives battery cells that are connected in parallel and serial to provide the energy to the electric motor of the vehicle.

The cell connecting system 100 comprises a support 103, typically made out of plastic, onto which two rows 105, 107 of a plurality of contact elements 109 and 111, typically made of aluminium, are mount, e.g. using a snap fit connection. The contact elements 109, 111 correspond to the electrical connection counterpart 2 of the embodiments described above.

In this embodiment, each contact element 109 and each contact element 111 comprises two contact element sections 109a, 109b and 111a, 111b respectively. The two contact element sections 109a, 109b are electrically connected to each other. The contact element sections 111a, 111b are also electrically connected to each other.

In use, a battery cell is positioned with its electrical plus and minus poles onto opposing contact sections. Thus, one battery cell on contact element section 109a, 111a and one battery cell on contact element sections 109b, 111b. Therefore, the battery cells are arranged in parallel. In a variant, less or more than two cells could be arranged in parallel. The battery cell is usually welded to the contact element sections to ensure a reliable electrical and mechanical connection.

In row 105, the neighbouring contact element 113 is electrically isolated from the contact element 109 via an isolating element 115, usually integrally formed with the support. In the opposing row, the neighbouring contact element 117 is electrically connected to the contact element 111. Thus, the battery cells mount on contact elements 113 and 117 will be mount in series with respect to the battery cells mount on contact elements 109 and 111. The arrangement of pairs of battery cells in parallel connected in series with the neighbouring pair of battery cell is realized over the entire rows 105 and 107. Thus, pairs of electrically connected contact elements are separated from the subsequent pair of electrically connected elements by an isolating element 115. In this embodiment, only the contact element 109 in row 105 and the contact element 149 in row 107 are not electrically connected to a neighbouring contact element.

The cell connecting system 100 is connected to neighbouring cell connecting systems or the motor via the bus bars 119 and 121.

The cell connecting system 100 further comprises a printed circuit board (PCB) 123 with a cell monitoring unit 125. The monitoring unit 125 on the PCB 123 is electrically connected to at least some of the contact elements 109, 111, 113, 115 to monitor a parameter of the battery cell, e.g. temperature, capacitance, e.g.to balance the capacitance, or its charging state. The connection is realized using sensing cables, here as flexible flat cables 127, 129, 131 and 133, also called flexible flat conductor cables in the embodiments described above.

As can be seen in the enlarged view 135, the flexible flat cable 133, comprises a plurality, here six, parallel wires 137a-f, here copper wires, isolated from each other by an electrical isolation 139, in this embodiment embedded in an extruded PVC. Three of the wires, 137c, 137d and 137e are electrically and mechanically connected to one and only one contact element, here 145, 147 and 149. In addition, as can be seen on Figure 1, each pair of opposing contact elements only has one wire connected. Here wire 137d and contact element 147, whereas the opposing contact element in row 105 is without connection to the flexible flat cable 127 to monitor the battery cells mount. Concerning the opposing contact elements 109a and 111a, both elements are connected to their corresponding flexible flat cable 129 and 131.

The flexible flat cable 133 has an exposed region 141, in which the wire 143, corresponding to wire 137c, is devoid of its electrical isolation. Wire 143 is welded to the contact element 145, typically by ultrasonic welding. To carry out the ultrasonic welding, also the side opposite to where the contact with the contact element 145 is realized needs to be devoid of the electrical isolation 139 as can be seen in Figure 1, as a sonotrode using to carry out the welding needs to be positioned onto the wire. Usually, the surface, onto which the sonotrode was applied, carries a visible imprint of the sonotrode's contact surface.

According to the invention, the exposed region 141 facing the contact element 145 comprises surface area enhancing features, like bumps. In this context, surface area enhancing feature means a surface with a larger area than a smooth surface of the copper wire, obtained after removal of the electrical isolation 139 e.g. using a CO2 laser and subsequent cleaning, like a mechanical cleaning using metal and/or plastic brushes, e.g. round brushes.

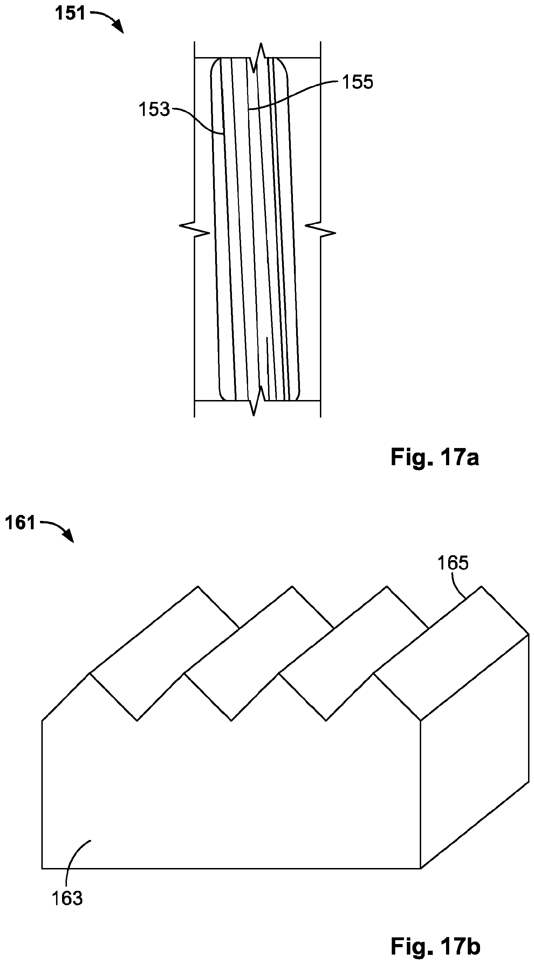

Figures 17a to 17c illustrate three different variants of surface area enhancing features on the exposed region 141 of the wire 143 according to the invention. The surface area enhancing features are on the side of the wire that will be in contact with the contact element 145 as shown in Figure 16.

Figure 17a illustrates the surface of the exposed region 151 of wire 153 after the application of a scratching tool. Scratches 155 are preferably provided over the entire surface of the exposed area and enhance the surface area compared to a smooth surface.

Figure 17b illustrates the surface of the exposed region 161 of wire 163 after the application of a stamping punch, leading to patterned surface area enhancing features in the form of linear bumps 165 extending along the longer side of exposed region 161. In a further variant, the linear bumps 165 could extend along the short side or be oblique. In this embodiment, all linear bumps 165 have the same shape. In a variant, they could also be different, e.g. higher towards the edge. The linear bumps 165 have a height of up to 0,5mm, in particular up to 0,2mm, more in particular a height of up to 0,1mm. Furthermore the peaks of directly neighbouring bumps have a distance from each other of up to 5mm, in particular of up to 0,2mm.

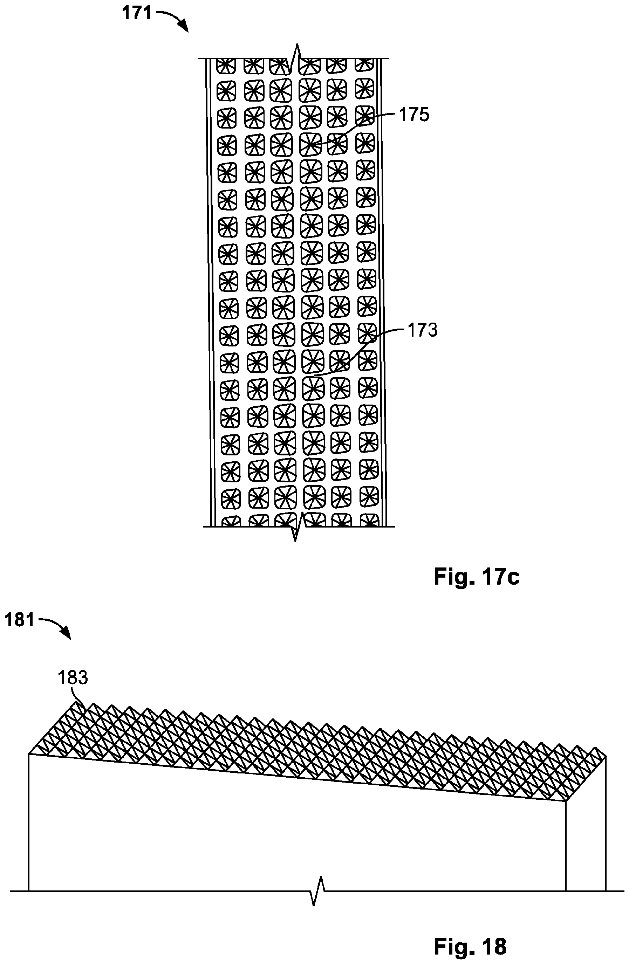

Figure 17c illustrates the surface of the exposed region 171 of wire 173 after the application of a stamping punch 181, as illustrated in figure 18, leading to patterned surface area enhancing features in the form of an array of pyramids 175 over the entire exposed region 171. In this embodiment, the pyramids 175 are peaked pyramids with an essentially rectangular, in particular essentially square based shape, and a flank-angle of about 30° to 60°, in particular 45°. The pyramids 175 have a height of up to 0,5mm, in particular up to 0,2mm, more in particular a height of up to 0,1mm. Furthermore, the peaks of directly neighbouring pyramids have a distance from each other of up to 5mm, in particular of up to 0,2mm.

As shown in Figure 18, the stamping punch 181 comprises an array of regularly arranged pyramids 183.

Instead of embossing the surface area enhancing features into the surface of the wire 163 or 173, it is also possible to use a laser patterning process.

The invention also relates to a method for attaching a sensing cable to a contact element of a cell connecting system as described above and comprising the steps of, removing the electrical isolation 139 from the flexible flat cables 127 to 133 to form exposed regions 141, 151, 161, 171 and cleaning the exposed regions. This step is then followed by a surface area enhancing features forming step using a stamping punch or scratching tool or by laser structuring to obtain one of the structures as shown in Figures 17a, 17b or 17c. Subsequently, the electrical and mechanical connection between the exposed regions 141, 151, 161, 171 of the wires 143, 153, 163, 173 is realized via welding, in particular ultrasonic or laser welding.

According to a variant, the forms as illustrated in Figures 17a to 17c could also or alternatively be provided on the surface of the contact element 145.

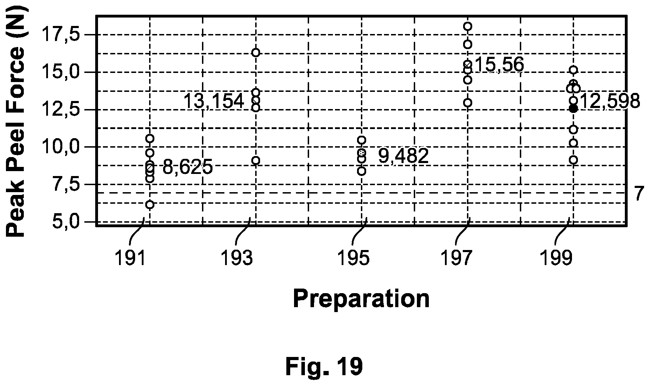

Figure 19 illustrates the results obtained after a 90° peel tension test as described above, the test satisfying Cmk >1,67. It shows the individual measurements and the average value.

For all samples the same materials, aluminium and copper were used for the contact element respectively the wire and the same ultrasonic process was applied.

Sample 191 corresponds to a comparative sample having a smooth surface. As can be seen the peel tension test is satisfying as the average value of 8,625N is higher than the needed 7N, see dotted horizontal line. One of the measurements was below 7N.

Sample 193 corresponds to surface area enhancement features in the form of peaked pyramids as illustrated in Figure 17c. They were obtained by using a stamping punch as illustrated in Figure 18. The peaked pyramids on the wire essentially show a square ground surface along the 0° and 90° direction, and on average present a distance between the peaks of 0,4mm, a height of 0,2 mm and a flank angle of 45°. The average peel off force obtained is 13,154N with all measurements above 7N.

Sample 195 corresponds to surface area enhancement features in the form of linear pumps as illustrated in Figure 17b, a distance between the peaks of 0,2mm, a height of 0,1mm and a flank angle of 45°. The average peel off force obtained is 9,482N with all measurements above 7N.

Sample 197 corresponds to surface area enhancement features in the form of peaked pyramids as illustrated in Figure 17c. They were obtained by using a stamping punch as illustrated in Figure 18. The peaked pyramids on the wire essentially show a square ground surface along the 0° and 90° direction, and on average present a distance between the peaks of 0,2mm, a height of 0,1mm and a flank angle of 45°. The average peel off force obtained is 15,56N with all measurements above 7N.

Sample 199 corresponds to surface area enhancement features in the form of scratches. The average peel off force obtained is 12,598N with all measurements above 7N.

All samples according to the invention have a higher peel off force compared to a wire with a smooth surface. The best results are obtained with Sample 197 showing an improvement of about 80% to the comparative sample.

A number of embodiments of the invention have been described. Nevertheless, it is understood that various modifications and enhancements may be made without departing the following claims. In particular, additional embodiments according to the invention are achieved by combining embodiments concerning the first object of the invention with embodiments according to the second object of the invention.

### List of reference numerals

- 1: conductor cable, here flexible flat conductor cable
- 2: electrical connection counterpart
- 3: electrical conductor
- 4: insulation sheath
- 5: contact section

- 7: contact side
- 8: upper side electrical contact
- 9: recess in the insulation sheath
- 10: further conductor
- 11: second direction
- 12: first direction
- 13: contact plane
- 14: cable section
- 15: first weld spot
- 16: second weld spot
- 17: first partial section
- 18: second partial section
- 19: first section
- 20: second section
- 21: bend
- 22: insulating material
- 23: first battery
- 24: second battery
- 25: third battery
- 26: first terminal
- 27: second terminal
- 28: third terminal
- 29: additional electrical conductor

- 31: droplet
- 33: surface side
- 35: laser pulse
- 37: laser
- 39: pressure wave
- 41: further laser pulse
- 42: weld area
- 43: weld
- 51: stamping punch
- 53: stamping surface
- 55: enlarged zone
- 57: stamping surface
- 59: structured surface
- 61: pyramidal shape
- 63: part of the contact section 5
- 65: embossed surface of electrical connection counterpart 2
- 67: height of imprint
- 69: interface plane
- 71: embossed area
- 73: enlarged zone
- 75: interface
- 77: surface enhancing features
- 79: laser
- 81: weld

- 100: cell connecting system
- 103: support
- 105: row
- 107: second row
- 109: contact element
- 109a: contact element section
- 109b: contact element section
- 111: contact element
- 111a: contact element section
- 111b: contact element section
- 113: neighbouring contact element
- 115: isolating element
- 117: neighbouring contact element
- 119: bus bar
- 121: bus bar
- 123: printed circuit board (PCB)
- 125: cell monitoring unit
- 127: flexible flat cable
- 129: flexible flat cable
- 131: flexible flat cable
- 133: flexible flat cable
- 135: enlarged view
- 137a - f: wires
- 139: electrical isolation
- 141: exposed region
- 143: wire in exposed region
- 145: contact element
- 147: contact element
- 149: contact element
- 151: exposed region
- 153: wire
- 155: surface scratch as surface area enhancing feature
- 161: exposed region
- 163: wire
- 165: linear bumps as surface area enhancing feature
- 171: exposed region
- 173: wire
- 175: peaked pyramids as surface area enhancing feature
- 181: stamping punch with peaked pyramids
- 191: comparative example
- 193: punched big pyramids
- 195: punched linear bumps
- 197: punched small pyramids
- 199: scratched surface area enhancing features

## Claims

1. Device with an electrical contact between an electrical conductor (3) of a conductor cable (1), in particular a flexible flat conductor cable, and an electrical connection counterpart (2), the conductor (3) is embedded in an insulation sheath (4) of the conductor cable (1) in a contact plane (13), where the electrical conductor (3) is stripped of the insulation sheath (4) in a predetermined contact section (5) at least on one contact side (7), where the contact section (5) of the conductor is bent out with the contact side (7) from the contact plane (13) to beyond the insulation sheath (4), where the contact side (7) of the contact section (5) of the conductor (3) rests on the electrical connection counterpart (2) and is connected directly to the electrical connection counterpart (2).

2. Device according to one of claims 1, wherein the contact section is at least partially embossed into the electrical connection counterpart.

3. Device according to claim 2, wherein the interface between the contact section and the electrical connection counterpart is positioned below the surface of the connection counterpart immediately adjacent the interface, in particular up to about 0,1 to 0,5mm, more in particular up to about 0,2 to 0,3 mm below the surface.

4. Device according to claim 2 or 3, the surface of the contact section and the surface of the electrical connection counterpart comprise mating surface area enhancing features at the interface.

5. Device according to one of claims 1 to 4, where the contact section (5) of the conductor (3) is bent with the contact side (7) in a first direction (12) out of the contact plane (13) to beyond an outer side of the insulation sheath (4), where the contact side (7) of the contact section of the conductor (3) rests on the electrical connection counterpart (2) and is directly connected to the electrical connection counterpart, and where the conductor cable (1) is bent in the region of the contact section (5) in a second direction (11), where the second direction (11) points in the direction opposite to the first direction (12).

6. Method for producing a device according to one of the preceding claims, where an electrical conductor of a conductor cable, in particular a flexible flat conductor cable, is embedded in a contact plane in an insulation sheath of the conductor cable, where the conductor is stripped of the insulation sheath in a predetermined contact section at least on one contact side, comprising the steps of:
a) bending the contact section of the conductor out of the contact plane to at least one outer side of the insulation sheath,
b) placing the conductor cable on the connection counterpart, in particular after the conductor has been bent out of the contact plane,
c) placing the contact side of the contact section of the conductor on the electrical connection counterpart, and then
d) connecting the contact side of the contact section directly to the electrical connection counterpart.

7. Method according to claim 6, where the contact side of the electrical conductor is welded to the electrical connection counterpart, in particular using a laser welding or ultrasonic welding method.

8. Method according to claim 7, comprising a step of down-holding the contact side of the electrical conductor towards the electrical connection counterpart prior to welding using a pressure wave formed by initiating a phase transition in a pressure creating material, in particular from a liquid phase or solid phase to a gas phase, and/or an explosion.

9. Method according to claim 8, wherein the pressure wave formation comprises a step of hitting the pressure creating material with one or more laser pulses, in particular using the same laser as for welding.

10. Method according to claim 8 or 9, wherein the pressure creating material is provided in the form of a droplet or cladding on or over the contact section (5).

11. Method according to one of claims 6 to 10, where the contact section of the conductor is bent with the contact side in a first direction from the contact plane projecting to beyond an outer side of the insulation sheath, where the conductor cable is subsequently moved in the direction towards the connection counterpart and the contact side of the contact section of the conductor is placed on the electrical connection counterpart and is connected directly to the electrical connection counterpart.

12. Method according to claim 11, where the conductor cable is bent in the region of the contact section in a second direction before placing the conductor on the connection counterpart and before the welding, where the second direction points in a direction opposite to the first direction.

13. Method according to one of the claims 6 to 12, where the contact section of the conductor is separated into a first and a second partial section, and where at least the first partial section is bent out of the contact plane, where the first partial section is placed on the connection counterpart and is connected with the contact side to the connection counterpart.

14. Method according to one of claims 6 to 13, wherein steps a) and c) are realized at the same time by embossing the contact section (5) in the electrical connection counterpart (2).

15. Method according to claim 14, wherein embossing is realized using a stamping punch (51) having a flat or structured surface.

16. Device according to one of claims 1 to 5, wherein the contact side (7) of the contact section (5) of the electrical conductor (3) is connected to the electrical connection counterpart (2) by way of several contact points (15, 16).

17. Device according to one of claims 1 to 5 or 16, where the contact section (5) of the electrical conductor (3) is separated into two partial sections (17, 18), and where at least one partial section (17, 18) of the electrical conductor (3) rests with the contact side (7) on the electrical connection counterpart (2) and is connected to the connection counterpart (2).

18. Device according to one of claims 1 to 5 or 16 or 17, where the contact section (5) of the electrical conductor (3) is embedded in insulating material (22), in particular in electrically insulating potting material.

19. Device according to one of the claims 1 to 5 or one of claims 16 to 18, where the connection counterpart (2) and the conductor (3) are formed from different electrically conductive materials.

20. Device according to claim 19, where the connection counterpart (2) is made from aluminium and the conductor (3) from copper.

21. Device according to one of the claims 1 to 5 or one of claims 16 to 20, where the electrical connection counterpart (2) is a contact of an electrical terminal (26, 27, 28) of a battery (23, 24, 25), in particular a vehicle battery.

22. Device according to one of the claims 1 to 5 or one of claims 16 to 21, where the electrical conductor (3) is connected to the electrical connection counterpart (2) by way of a welded connection, in particular a laser or ultrasonic welded connection.

23. A cell connecting system for a vehicle battery module, in particular for an electric or hybrid vehicle, comprising a device according to one of claims 1 to 5 or according to one of claims 16 to 22,
- wherein the electrical connection counterpart comprises a contact element (109, 111) for receiving an electrical pole of at least one battery cell
- the conductor cable comprises a sensing cable (127, 129, 131, 133) comprising a wire (137a-e) electrically and mechanically connecting a cell monitoring unit (125) and the contact element (109, 111),
**characterized in that**
the surface of the wire and/or the contact element comprises surface area enhancing features (155, 165, 175) in the area of contact with each other.

24. A cell connecting system for a vehicle battery module, in particular for an electric or hybrid vehicle, comprising
- a contact element (109, 111) for receiving an electrical pole of at least one battery cell
- a sensing cable (127, 129, 131, 133) comprising a wire (137a-e) electrically and mechanically connecting a cell monitoring unit (125) and the contact element (109, 111),
**characterized in that**
the surface of the wire and/or the contact element comprises surface area enhancing features (155, 165, 175) in the area of contact with each other.

25. The cell connecting system according to claim 23 or 24, wherein the surface area enhancing features (165, 175) comprise a plurality of bumps.

26. The cell connecting system according to claim 25, wherein the bumps (165) extend linearly, in particular in parallel to the longer side of the area of contact.

27. The cell connecting system according to claim 25, wherein the bumps have a pyramidal shape (175), in particular a peaked pyramidal shape.

28. The cell connecting system according to claim 27, wherein the pyramidal shape (175) has a rectangular, in particular square base shape, and a flank-angle of about 30° to 60°, in particular 45°.

29. The cell connecting system according to one of claims 25 to 28, wherein the bumps (155, 165, 175) have a height of up to 0,5mm, in particular up to 0,2mm, more in particular a height of up to 0,1 mm.

30. The cell connecting system according to one of claims claim 25 to 29, wherein the peaks of directly neighbouring bumps (165, 175) have a distance from each other of up to 5mm, in particular of up to 0,2mm.

31. The cell connecting system according to one of claims 23 to 30, wherein the wire (153, 163, 173) and the contact element (145) are welded together, in particular ultrasonic welded together.

32. The cell connecting system according to one of claims 23 to 31, wherein the contact element (145) and the wire (153, 163, 173) are made of different materials, in particular of aluminium respectively copper.

33. The cell connecting system according to one of claims 23 to 32, comprising a plurality of contact elements arranged in two rows (105, 107), allowing a serial electrical connection of battery cells, and wherein one of mutually opposing contact elements is electrically and mechanically connected with the wire of the sensing cable (127, 129, 131, 133).

34. The cell connecting system according claim 33, wherein the sensing cable (127, 129, 131, 133) comprises a plurality of parallel wires (137a-f), in particular flat wires, embedded in an electrical isolation (139), wherein each one of the wires that are connected to a contact element is electrically and mechanically connected to a different one of the contact elements and wherein the electrical isolation is removed in each area of contact.

35. Method according to one of claims 6 to 15 for obtaining a cell connecting system according to claim 23, wherein the surface area enhancing features are realized using a stamping punch (181) or scratching tool or by laser structuring.

36. Method for attaching a sensing cable to a contact element of a cell connecting system according to one of claims 24 to 34, comprising the steps of removing an isolation from the sensing wire to form an exposed region of the wire and forming surface area enhancing features on the exposed region of the wire, wherein the surface area enhancing features are realized using a stamping punch (81) or scratching tool or by laser structuring.

37. Method for attaching a sensing cable to a contact element of a cell connecting system according to one of claims 24 to 34, wherein the surface area enhancing features are realized using a stamping punch (181) or scratching tool or by laser structuring.

38. Method according to claim 36 or 37, wherein the stamping punch (181) or the scratching tool or the laser structuring is applied on the side of wire and/or the contact element on which the electrical and mechanical connection will be established.

39. Method for attaching a sensing cable to a contact element according to one of claims 36 to 38, wherein the electrical and mechanical connection is realized via welding, in particular by laser or ultrasonic welding.
